# EUROPEAN PATENT APPLICATION

(11) **EP 4 826 723 A1**
(43) Date of publication of application: **21.10.2026**
(21) Application number: 26165769.6
(22) Date of filing: 18.03.2026
(51) Int. Cl.: G11C 8/12, G11C 7/10

(54) **MEMORY DEVICE HAVING WIDE IO, STORAGE DEVICE INCLUDING THE SAME AND METHOD OF OPERATION THEREOF**

(30) Priority: 17.04.2025 KR 20250050322
(71) Applicant: Samsung Electronics Co., Ltd., Suwon-si, Gyeonggi-do 16677 (KR)
(72) Inventor: SONG, Seongjin, 16677 Suwon-si, Gyeonggi-do (KR); CHOO, Gyosoo, 16677 Suwon-si, Gyeonggi-do (KR); JEONG, Youngseok, 16677 Suwon-si, Gyeonggi-do (KR); SONG, Kiwhan, 16677 Suwon-si, Gyeonggi-do (KR); KIM, Wandong, 16677 Suwon-si, Gyeonggi-do (KR); LEE, Hyunee, 16677 Suwon-si, Gyeonggi-do (KR); SONG, Seunghwan, 16677 Suwon-si, Gyeonggi-do (KR)
(74) Representative: Kuhnen & Wacker Patent- und Rechtsanwaltsbüro PartG mbB

(57) **Abstract**

A memory device (30b) includes a plurality of planes (31, 32) and a control circuit. The plurality of planes (31, 32) may be included in a chip, and each of which may include a cell array and a page buffer. The control circuit, in a first mode, may enable or disable at least one first plane (31) among the plurality of planes (31, 32) based on a signal (nCE1) received through a first chip enable pad (P01) and output a signal (RnB1) that indicates a state of the at least one first plane (31) through a first ready/busy pad (P02). The control circuit may also enable or disable at least one second plane (32) among the plurality of planes (31, 32) based on a signal (nCE2) received through a second chip enable pad (P05) and output a signal (RnB2) that indicates a state of the at least one second plane (32) through a second ready/busy pad (P06).

## Description

### BACKGROUND

### 1. Field of the Invention

Example embodiments relate to a memory device, and more specifically, a memory device having wide input/output (IO), a storage device including the same, and a method of operation thereof.

### 2. Description of the Related Art

A memory device may be used to store data in various applications, and according to a received command, may update or output stored data. For example, a memory device may respond to a write command to store data and respond to a read command to output stored data. In an application such as artificial intelligence (Al), a memory device may be required to have not only high bandwidth but also high responsiveness to various operations.

### SUMMARY

An aspect provides a memory device providing high responsiveness to various operations, a storage device including the same, and a method of operation thereof.

According to an aspect, there is provided a memory device including a plurality of planes included in a chip, and each of which may include a cell array and a page buffer, and a control circuit. The control circuit, in a first mode, may be configured to enable or disable at least one first plane among the plurality of planes based on a signal received through a first chip enable pad and output a signal that indicates a state of the at least one first plane through a first ready/busy pad, and to enable or disable at least one second plane among the plurality of planes based on a signal received through a second chip enable pad and output a signal that indicates a state of the at least one second plane through a second ready/busy pad.

According to another aspect, there is provided an operating method of a memory device including a plurality of planes included in a chip, and each of which may include a cell array and a page buffer, the operating method including, in a first mode, enabling or disabling at least one first plane among the plurality of planes based on a signal received through a first chip enable pad, in the first mode, outputting a signal that indicates a state of the at least one first plane through a first ready/busy pad, in the first mode, enabling or disabling at least one second plane among the plurality of planes based on a signal received through a second chip enable pad, and in the first mode, outputting a signal that indicates a state of the at least one second plane through a second ready/busy pad.

According to another aspect, there is provided a storage device, including, a first memory chip including a plurality of planes, each of which may include a cell array and a page buffer and a control chip configured to provide a first chip enable signal that enables or disables at least one first plane among the plurality of planes and a second chip enable signal that enables or disables at least one second plane among the plurality of planes to the first memory chip, and to receive a first ready/busy signal that indicates a state of the at least one first plane and a second ready/busy signal that indicates a state of the at least one second plane from the first memory chip.

### BRIEF DESCRIPTION OF THE FIGURES

These and/or other aspects, features, and advantages of the invention will become apparent and more readily appreciated from the following description of example embodiments, taken in conjunction with the accompanying drawings of which:
FIG. 1 is a block diagram illustrating a storage device according to an example embodiment of the present disclosure;
FIG. 2 is a block diagram illustrating a memory device according to an example embodiment of the present disclosure;
FIGS. 3A and 3B are block diagrams illustrating examples of a memory device according to example embodiments of the present disclosure;
FIGS. 4A and 4B are timing diagrams illustrating examples of an operation of a memory device according to example embodiments of the present disclosure;
FIGS. 5A and 5B are block diagrams illustrating examples of a memory device according to example embodiments of the present disclosure;
FIGS. 6A through 6C illustrate examples of a memory device according to example embodiments of the present disclosure;
FIGS. 7A and 7B are block diagrams illustrating examples of a memory device according to example embodiments of the present disclosure;
FIGS. 8A through 8D are block diagrams illustrating examples of a memory device according to example embodiments of the present disclosure;
FIG. 9 is a flowchart illustrating an operating method of a memory device according to an example embodiment of the present disclosure;
FIG. 10 is a flowchart illustrating an operation of a memory device according to an example embodiment of the present disclosure;
FIGS. 11A and 11B are flowcharts illustrating examples of an operating method of a memory device according to example embodiments of the present disclosure;
FIG. 12 is a diagram illustrating a storage device according to an example embodiment of the present disclosure; and
FIG. 13 is a block diagram illustrating a system according to an example embodiment of the present disclosure.

### DETAILED DESCRIPTION

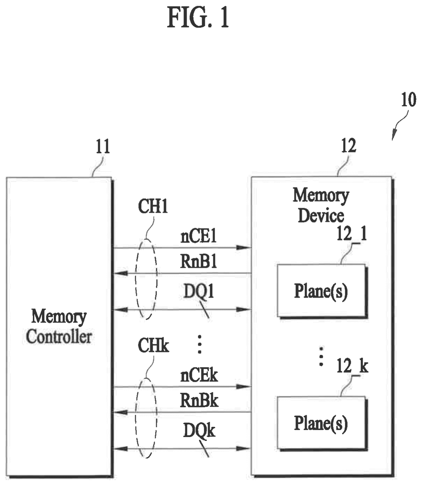

FIG. 1 is a block diagram illustrating a storage device 10 according to an example embodiment of the present disclosure. As illustrated in FIG. 1, the storage device 10 may include a memory controller 11 and a memory device 12 and may be referred to as a storage system or a memory system. In some example embodiments, the memory controller 11 and the memory device 12 may be manufactured through a semiconductor process and included in one package or two or more separate packages. In FIG. 1, k may be an integer greater than 1.

The memory controller 11 may communicate with a host and the memory device 12 and control data exchange between the host and the memory device 12. For example, the memory controller 11 may write data to the memory device 12 or read data stored in the memory device 12 according to a request received from the host. The memory controller 11 may communicate with the memory device 12 through a plurality of channels. For example, as illustrated in FIG. 1, the memory controller 11 may communicate with the memory device 12 through a first channel CH1 to a k-th channel CHk. The memory controller 11 may independently communicate with the memory device 12 through each of the first channel CH1 to the k-th channel CHk. For example, the memory controller 11 may read data from the memory device 12 through the k-th channel CHk while writing data to the memory device 12 through the first channel CH1.

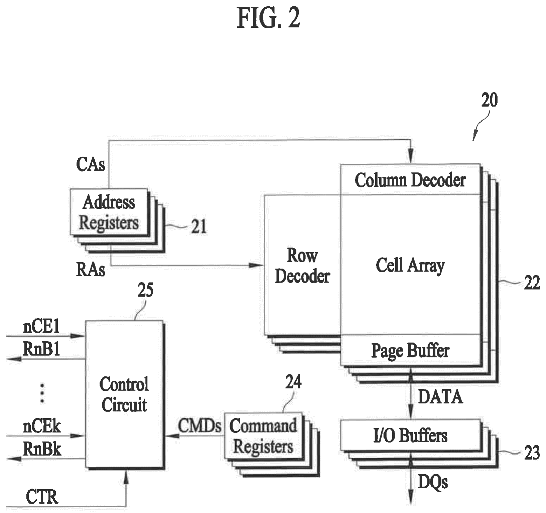

The memory device 12 may correspond to a chip (or die). A wafer may be manufactured through a semiconductor process, and a plurality of chips may be separated from the wafer through dicing. The plurality of chips that are separated from the wafer may have an identical structure, and for example, correspond to an identical memory device. Herein, unless described otherwise, a memory device may refer to a chip, in other words, a memory chip. The memory device 12, as a chip, may include a plurality of planes. For example, as illustrated in FIG. 1, the memory device 12 may include at least one first plane 12_1 to at least one k-th plane 12_k. As described later with reference to FIG. 2, one plane may include a cell array and a page buffer, and data may be independently written to or read from a different plane.

In some example embodiments, the memory device 12 may include volatile memory cells. For example, the memory device 12 may be dynamic random access memory (DRAM) devices, such as double data rate (DDR), synchronous dynamic random access memory (SDRAM), DDR2 SDRAM, DDR3 SDRAM, DDR 4 SDRAM, DDR 5 SDRAM, DDR6 SDRAM, low power double data rate (LPDDR) SDRAM, LPDDR2 SDRAM, LPDDR3 SDRAM, LPDDR4 SDRAM, LPDDR4X SDRAM, LPDDR5 SDRAM, graphics double data rate (GDDR) synchronous graphics random access memory (SGRAM), GDDR2 SGRAM, GDDR3 SGRAM, GDDR4 SGRAM, GDDR5 SGRAM, and GDDR6 SGRAM. In some example embodiments, the memory device 12 may include a vertical channel transistor (VCT). In some example embodiments, the memory device 12 may include non-volatile memory cells as a non-volatile memory device. For example, the memory device 12 may be a non-volatile memory device such as a NAND flash memory, a NOR flash memory, and a resistive random access memory (RRAM). Hereinafter, a flash memory device will be mainly described as a non-volatile memory device, but example embodiments of the present disclosure is not limited thereto.

The memory device 12 may have wide input/output (I/O) for high bandwidth. For example, as illustrated in FIG. 1, the memory device 12 may transmit and receive data to and from the memory controller 11 through a first DQ set DQ1 to a k-th DQ set DQk, and each of the first DQ set DQ1 to the k-th DQ set DQk may correspond to a multi-bit (for example, 8-bit) signal. An application such as Al may need not only high bandwidth but also high responsiveness to various operations. For example, sequential read throughput that repetitively loads an Al model from the storage device 10 in an inference process may be important to performance of an Al application. In addition, the storage device 10 may be needed to have high responsiveness to various operations such as key-value (KV) caching and checkpoint backup.

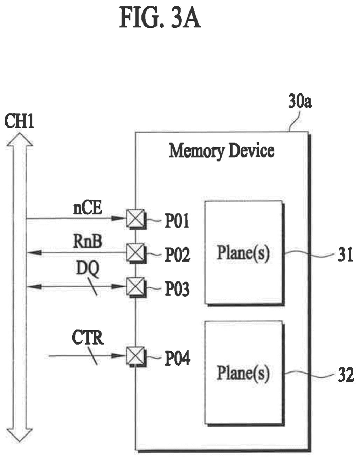

As illustrated in FIG. 1, the memory device 12, as a chip, may communicate with the memory controller 11 through a plurality of channels, in other words, the first channel CH1 to the k-th channel CHk. Accordingly, the memory device 12 may provide not only high bandwidth due to wide I/O, but also high responsiveness to various operations based on independence of a channel. For the independence of a channel, a single channel may include a chip enable signal and a ready/busy signal together with a DQ set. For example, as illustrated in FIG. 1, the first channel CH1 may include a first chip enable signal nCE1, a first ready/busy signal RnB1, and a first DQ set DQ1, and the k-th channel CHk may include a k-th chip enable signal nCEk, a k-th ready/busy signal RnBk, and a k-th DQ set DQk. As described later with reference to FIG. 3A and the like, channels may share at least one control signal received from the memory controller 11.

The chip enable signal may instruct to enable or disable at least one plane that is included in the memory device 12. For example, the memory controller 11 may transmit the first chip enable signal nCE1 to the memory device 12 to enable or disable the at least one first plane 12_1, or transmit the k-th chip enable signal nCEk to the memory device 12 to enable or disable the at least one k-th plane 12_k. The memory device 12 may enable the at least one first plane 12_1 in response to an activated first chip enable signal nCE1, and meanwhile, may disable the at least one first plane 12_1 in response to an inactivated first chip enable signal nCE1. In addition, the memory device 12 may enable the at least one k-th plane 12_k in response to an activated k-th chip enable signal nCEk, and meanwhile, may disable the at least one k-th plane 12_k in response to an inactivated k-th chip enable signal nCEk. Herein, a chip enable signal may be assumed to be an active low signal, and accordingly, an activated chip enable signal may have a logic low level.

The ready/busy signal may indicate a state of the memory device 12. For example, the memory device 12 may output an activated first ready/busy signal RnB1 when the at least one first plane 12_1 is in a ready state, and meanwhile, may output an inactivated first ready/busy signal RnB1 when the at least one first plane 12_1 is in a busy state. In addition, the memory device 12 may output an activated k-th ready/busy signal RnBk when the at least one k-th plane 12_k is in a ready state, and meanwhile, may output an inactivated k-th ready/busy signal RnBk when the at least one k-th plane 12_k is in a busy state. The memory controller 11 may identify a state of the at least one first plane 12_1 based on the first ready/busy signal RnB1 that is received from the memory device 12 and identify a state of the at least one k-th plane 12_k based on the k-th ready/busy signal RnBk that is received from the memory device 12. Herein, the ready/busy signal may be assumed to be an active high signal, and accordingly, a ready/busy signal that indicates a ready state may have a logic high level, and a ready/busy signal that indicates a busy state may have a logic low level.

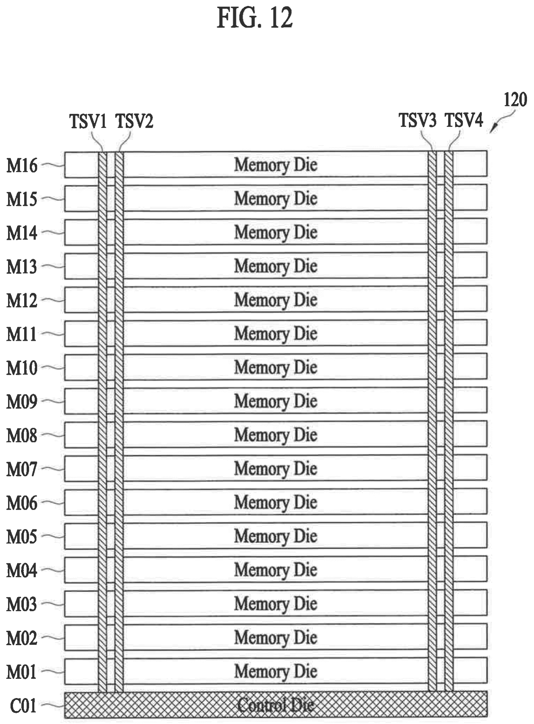

The memory device 12 may include pads for signals that are provided to the memory controller 11 or received from the memory controller 11. A pad may be a conductor that is exposed outside the memory device 12 and may be referred to as a pin. In some example embodiments, as described later with reference to FIG. 12, the pad may correspond to a through silicon via (TSV).

As described later with reference to the drawings, in some example embodiments, a channel between the memory controller 11 and the memory device 12 may be reconfigured. In addition, in some example embodiments, a data path between a channel and a plane may be reconfigured. Accordingly, the memory device 12 may have high flexibility and may be adaptively used in various applications. As a result, productivity of the memory device 12 may increase, and various modes of an application may be supported.

FIG. 2 is a block diagram illustrating a memory device 20 according to an example embodiment of the present disclosure. As illustrated in FIG. 2, the memory device 20 may include address registers 21, planes 22, I/O buffers 23, command registers 24, and a control circuit 25.

The address registers 21 may store an address that is provided from outside the memory device 20, for example, from the memory controller 11 of FIG. 1. In some example embodiments, the address registers 21 may receive addresses from the I/O buffers 23. The address registers 21 may extract row addresses RAs and column addresses CAs from the address. As illustrated in FIG. 2, the address registers 21 may provide the row addresses RAs and the column addresses CAs to the planes 22.

The planes 22 may receive the row addresses RAs and the column addresses CAs from the address registers 21 and exchange data DATA with the I/O buffers 23. In some example embodiments, the memory device 20 may include an error correction code (ECC) engine between the planes 22 and the I/O buffers 23, and the planes 22 may exchange a codeword with the ECC engine. As illustrated in FIG. 2, a single plane may include a cell array, a row decoder, a column decoder, and a page buffer.

The cell array may include a plurality of memory cells. For example, in a flash memory, a memory cell may include a transistor that has a floating gate and store data that corresponds to a threshold voltage of the transistor. In some example embodiments, the cell array may include a single level cell (SLC) that stores a single bit or a multi-level cell (MLC) or a triple-level cell (TLC) that store two or more bits. The memory cells that are connected to an identical word line may be referred to as a page, and data that is stored in the page may be referred to as page data. The page buffer may store page data that is to be programmed in the cell array or page data that is read from the cell array. The cell array may include a plurality of blocks, and a single block may include a plurality of pages. Read and write operations may be performed in units of pages, and meanwhile, erase operation may be performed in units of blocks.

The row decoder may be connected to the cell array through word lines. The row decoder may activate one of the word lines based on one of the row addresses RAs, and one page may be selected in the cell array. The column decoder may select a portion of the page based on one of the column addresses CAs. For example, the column decoder may select the data DATA as a portion of page data. The page buffer may store the page data that is to be programmed in the cell array or the page data that is read from the cell array. The page buffer may exchange the data DATA as a portion of the page data with the I/O buffers 23.

As described above, a single plane may include the cell array, the row decoder, the column decoder, and the page buffer, and accordingly, each plane may operate independently. For example, while data that is stored in a first plane is read, data may be written in a second plane. In addition, when a block included in the first plane is erased, data that is stored in the second plane may be read. In some example embodiments, two or more planes may share at least one of the row decoder, the column decoder, and the page buffer, and two or more planes may operate independently from two or more other planes. Hereinafter, a structure where a single plane includes the cell array, the row decoder, the column decoder, and the page buffer may be used as a non-limiting example, but it should be noted that example embodiments are not limited thereto.

The I/O buffers 23 may exchange the data DATA with the planes 22, in other words, the page buffers. For example, the I/O buffers 23 may provide the data DATA that is received from DQ sets DQs to the page buffers and output the data DATA that is received from the page buffers through the DQ sets DQs. As described above with reference to FIG. 1, the memory device 20 may have wide I/O, and the DQ sets DQs may have a wide width, in other words, a large number of bits. Furthermore, each DQ set DQs may be included in one channel. In some example embodiments, the I/O buffers 23 may form a data path between the planes 22 and the DQ sets DQs based on a control of the control circuit 25. In some example embodiments, the I/O buffers 23 may receive not only the data DATA but also a command and/or an address from the DQ sets DQs and provide the command to the command registers 24 or the address to the address registers 21.

The command registers 24 may store a command that is provided from outside the memory device 20, for example, from the memory controller 11. In some example embodiments, the command registers 24 may receive commands from the I/O buffers 23. The command registers 24 may provide commands CMDs to the control circuit 25. In some example embodiments, the memory device 20 may receive a command/address signal that is distinguished from the DQ sets DQs from the memory controller 11 to receive a command and an address, and the DQ sets DQs may be used only for data.

The control circuit 25 may receive signals from outside the memory device 20, for example, from the memory controller 11. For example, as illustrated in FIG. 1, the control circuit 25 may receive a first chip enable signal nCE1 and a first ready/busy signal RnB1 that are included in the first channel CH1, and receive a k-th chip enable signal nCEk and a k-th ready/busy signal RnBk that are included in the k-th channel CHk. In addition, the control circuit 25 may receive at least one control signal CTR that the first channel CH1 and a second channel CH2 share. For example, the at least one control signal CTR may include at least one of a command latch enable signal, a read enable signal, and a write enable signal. The at least one control signal CTR may be received through at least one pad that is exposed from the memory device 20 with a chip enable signal, a ready/busy signal, and the like.

The control circuit 25 may receive the commands CMDs from the command registers 24. The control circuit 25 may identify a command by decoding the commands CMDs and control other elements of the memory device 20 according to an identified command. For example, the control circuit 25 may receive a read command, a write command, and an erase command and control other elements to perform a read operation, a write operation, and an erase operation. In some example embodiments, the control circuit 25 may receive the commands CMDs respectively corresponding to channels and control accesses to the planes according to each of the commands CMDs.

In some example embodiments, the control circuit 25 may identify a channel mode based on a signal received from outside the memory device 20 and reconfigure a channel based on the identified channel mode. For example, the control circuit 25 may reconfigure the channel based on an identified command and reconfigure the channel based on a signal that is received through at least one pad. In addition, the memory device 20 may include a non-volatile memory, for example, a one-time programmable (OTP) memory, and the control circuit 25 may program the non-volatile memory based on a command and/or a signal that is received from outside the memory device 20 and reconfigure a channel based on a value that is stored in the non-volatile memory. As described later with reference to the diagrams, reconfiguring the channel may include changing the number of the channels and width of the channel, and the like.

In some example embodiments, the control circuit 25 may identify a data path mode based on a signal received from outside the memory device 20 and control the I/O buffers 23 according to an identified data path mode to form a data path between the planes 22 and the DQ sets DQs. For example, the control circuit 25 may form a data path based on an identified command and form the data path based on a signal that is received through at least one pad. In addition, the memory device 20 may include the non-volatile memory, for example, the OTP memory, and the control circuit 25 may program the non-volatile memory according to the command and/or the signal that is received from outside the memory device 20 and reconfigure the data path based on a value that is stored in the non-volatile memory. Hereinafter, performing an operation of the control circuit 25 may be referred to as performing an operation of the memory device 20.

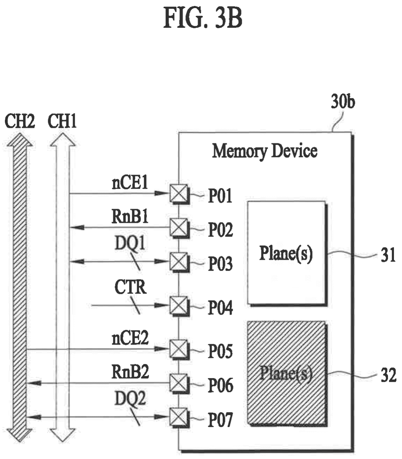

FIGS. 3A and 3B are block diagrams illustrating examples of a memory device according to example embodiments of the present disclosure. For example, the block diagram of FIG. 3A illustrates a memory device 30a that supports one channel, and the block diagram of FIG. 3B illustrates a memory device 30b that supports two channels.

Referring to FIG. 3A, the memory device 30a may include at least one first plane 31 and at least one second plane 32. In addition, the memory device 30a may include a first pad P01, a second pad P02, a third pad P03, and a fourth pad P04. As illustrated in FIG. 3A, the memory device 30a may receive a chip enable signal nCE through the first pad P01, output a ready/busy signal RnB through the second pad P02, transmit and receive a DQ set DQ through the third pad P03, and receive at least one control signal CTR through the fourth pad P04. Although a single pad is illustrated in FIG. 3A, the third pad P03 may correspond to a plurality of pads, and the fourth pad P04 may correspond to at least one pad.

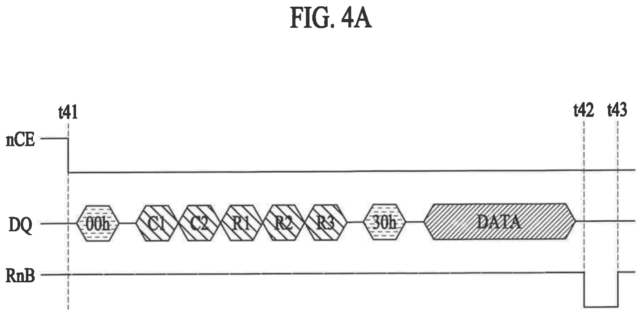

The at least one first plane 31 and the at least one second plane 32 may be accessed through a first channel CH1. For example, as illustrated in FIG. 3A, the memory device 30a may receive the chip enable signal nCE, transmit the ready/busy signal RnB, transmit and receive the DQ set DQ through the first channel CH1. Accordingly, as described later with reference to FIG. 4A, the at least one first plane 31 and the at least one second plane 32 may perform an identical operation, for example, a read operation, a write operation, or an erase operation at the same time.

Referring to FIG. 3B, a memory device 30b may include at least one first plane 31 and at least one second plane 32. In addition, the memory device 30b may include a first pad P01, a second pad P02, a third pad P03, a fourth pad P04, a fifth pad P05, a sixth pad P06, and a seventh pad P07. As illustrated in FIG. 3B, the memory device 30b may receive a first chip enable signal nCE1 through the first pad P01, output a first ready/busy signal RnB1 through the second pad P02, transmit and receive a first DQ set DQ1 through the third pad P03. The memory device 30b may receive at least one control signal CTR through the fourth pad P04. Furthermore, the memory device 30b may receive a second chip enable signal nCE2 through the fifth pad P05, output a second ready/busy signal RnB2 through the sixth pad P06, and transmit and receive a second DQ set DQ2 through the seventh pad P07. Although a single pad is illustrated in FIG. 3B, each of the third pad P03 and the seventh pad P07 may correspond to a plurality of pads, and the fourth pad P04 may correspond to at least one pad.

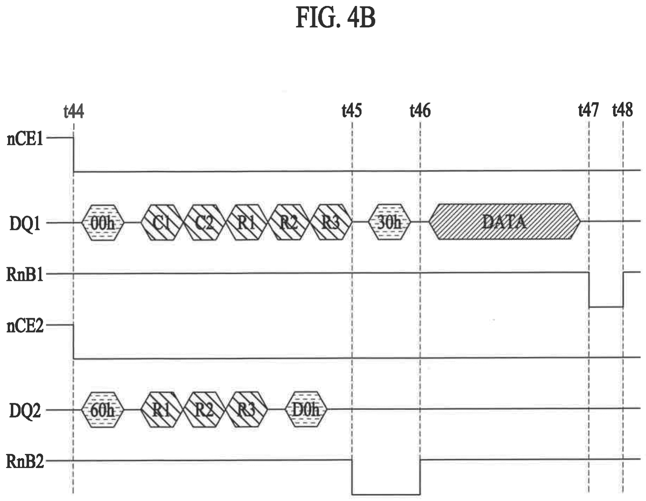

The at least one first plane 31 may be accessed through a first channel CH1 and the at least one second plane 32 may be accessed through a second channel CH2. For example, as illustrated in FIG. 3B, the memory device 30b may receive the first chip enable signal nCE1, transmit the first ready/busy signal RnB1, and transmit and receive the first DQ set DQ1 through the first channel CH1. In addition, the memory device 30b may receive the second chip enable signal nCE2, transmit the second ready/busy signal RnB2, and transmit and receive the second DQ set DQ2 through the second channel CH2. Accordingly, as described later with reference to FIG. 4B, the at least one first plane 31 and the at least one second plane 32 may perform an operation independently of each other.

FIGS. 4A and 4B are timing diagrams illustrating examples of an operation of a memory device according to example embodiments of the present disclosure. For example, the timing diagram of FIG. 4A illustrates an operation of the memory device 30a of FIG. 3A, and the timing diagram of FIG. 4B illustrates an operation of the memory device 30b of FIG. 3B. Hereinafter, FIG. 4A and FIG. 4B will be described with reference to FIG. 3A and FIG. 3B, and redundant details in the descriptions of FIG. 4A and FIG. 4B will be omitted.

Referring to FIG. 4A, a chip enable signal nCE may be activated at time t41. Accordingly, a control circuit of the memory device 30a may enable the at least one first plane 31 and the at least one second plane 32. Subsequently, the memory device 30a may sequentially receive a command "00h," column addresses "C1" and "C2," row addresses "R1," "R2," and "R3," and a command "30h" through a DQ set DQ. Command registers of the memory device 30a may receive commands from I/O buffers, and the control circuit may identify a read operation based on the commands that are provided from the command registers. In addition, address registers of the memory device 30a may store and provide the column addresses and the row addresses to the at least one first plane 31 and the at least one second plane 32. The at least one first plane 31 and the at least one second plane 32 may provide data DATA that is stored in memory cells corresponding to the row addresses and the column addresses, and the I/O buffers may sequentially output the data DATA through the DQ set DQ.

At time t42, a ready/busy signal RnB may be inactivated, and at time t43, the ready/busy signal RnB may be activated. The control circuit of the memory device 30a may output an inactivated ready/busy signal RnB at the time t42 to indicate a busy state of the at least one first plane 31 and the at least one second plane 32, and after the busy state ends, output an activated ready/busy signal RnB at the time t43 to indicate a ready state of the at least one first plane 31 and the at least one second plane 32. A memory controller may identify that the at least one first plane 31 and the at least one second plane 32 are in a ready state through the activated ready/busy signal RnB and provide a command for a next operation to the memory device 30a.

Referring to FIG. 4B, at time t44, a first chip enable signal nCE1 and a second chip enable signal nCE2 may be activated. Accordingly, a control circuit of the memory device 30b may enable the at least one first plane 31 and the at least one second plane 32. Subsequently, the memory device 30b may sequentially receive a command "00h," column addresses "C1" and "C2," row addresses "R1," "R2," and "R3," and a command "30h" through a first DQ set DQ1. Accordingly, the memory device 30b may output data DATA through the first DQ set DQ1.

At the time t44, after the second chip enable signal nCE2 is activated, the memory device 30b may sequentially receive a command "60h," row addresses "R1," "R2," and "R3," and a command "D0h" through a second DQ set DQ2. The control circuit of the memory device 30b may identify an erase operation based on the received commands. Accordingly, the control circuit may control the erase operation for a memory block corresponding to the row addresses "R1," "R2", and "R3."

At time t45, a second ready/busy signal RnB2 may be inactivated, and at time t46, the second ready/busy signal RnB2 may be activated. The control circuit of the memory device 30b may output an inactivated second ready/busy signal RnB2 to indicate a busy state of the at least one second plane 32, while the at least one second plane 32 performs an erase operation. After the erase operation of the at least one second plane 32 is completed, the control circuit may output an activated second ready/busy signal RnB2 to indicate a ready state of the at least one second plane 32. A memory controller may identify that the at least one second plane 32 is in a ready state through the activated second ready/busy signal RnB2 and provide a command for a next operation of the at least one second plane 32 to the memory device 30b through the second DQ set DQ2.

At time t47, the first ready/busy signal RnB1 may be inactivated, and at time t48, the first ready/busy signal RnB1 may be activated. The control circuit of the memory device 30b may output an inactivated first ready/busy signal RnB1 at the time t47 to indicate a busy state of the at least one first plane 31, and after the busy state ends, output an activated first ready/busy signal RnB1 at the time t48 to indicate a ready state of the at least one first plane 31. The memory controller may identify that the at least one first plane 31 is in a ready state through the activated first ready/busy signal RnB1 and provide a command for a next operation of the at least one first plane 31 to the memory device 30b through the first DQ set DQ1.

As described above with reference to FIGS. 4A and 4B, the at least one first plane 31 and the at least one second plane 32 may perform an identical operation at the same time in the memory device 30a of FIG. 3A, and meanwhile, at least one first plane 31 and the at least one second plane 32 in the memory device 30b of FIG. 3B may perform operations that are different from each other at the same time. Accordingly, the memory device 30b may provide high responsiveness to various operations, and performance of an application that includes the memory device 30b may increase.

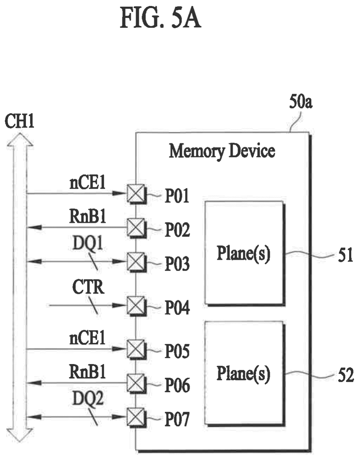

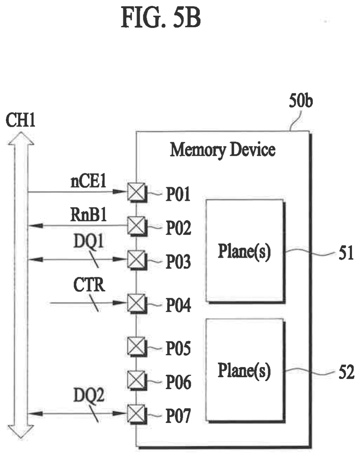

FIGS. 5A and 5B are block diagrams illustrating examples of a memory device according to example embodiments of the present disclosure. For example, the block diagrams of FIGS. 5A and 5B may indicate memory devices 50a and 50b that support two channels and communicate through one channel. Hereinafter, redundant details in the descriptions of FIGS. 5A and 5B will be omitted.

In some example embodiments, the memory devices 50a and 50b of FIGS. 5A and 5B may have the same structure as the memory device 30b of FIG. 3B, but may be set in a different mode. For example, when the memory devices 50a and 50b of FIGS. 5A and 5B are set in a first channel mode, as in the memory device 30b of FIG. 3B, at least one first plane 51 and at least one second plane 52 may be respectively accessed through two channels. Meanwhile, when the memory devices 50a and 50b of FIGS. 5A and 5B are set in a second channel mode or a third channel mode, as described later, the at least one first plane 51 and the at least one second plane 52 may be accessed through one channel, in other words, through a first channel CH1. As described above with reference to FIG. 2, a control circuit that is included in each of the memory devices 50a and 50b may set the first channel mode, the second channel mode, or the third channel mode. Hereinafter, as a non-limiting example, the memory device 50a of FIG. 5A may be assumed to be set in the second channel mode, and the memory device 50b of FIG. 5b set in the third channel mode.

Referring to FIG. 5A, the at least one first plane 51 and the at least one second plane 52 may be accessed through one channel, in other words, the first channel CH1 in the second channel mode. For example, as illustrated in FIG. 5A, in the memory device 50a, a first pad P01 and a fifth pad P05 may receive a first chip enable signal nCE1, and a second pad P02 and a sixth pad P06 may output a first ready/busy signal RnB1. A third pad P03 may transmit and receive a first DQ set DQ1, and a seventh pad P07 may transmit and receive a second DQ set DQ2. Accordingly, the first channel CH1 may have a width of a DQ set that corresponds to the sum of a width of the first DQ set DQ1 and a width of the second DQ set DQ2. The memory device 50a may receive at least one control signal CTR through a fourth pad P04. Unlike the memory device 50b of FIG. 5B described later, the memory device 50a may respond to the first chip enable signal nCE1 that is received through the fifth pad P05 and output the first ready/busy signal RnB1 through the sixth pad P06 in the second channel mode.

Referring to FIG. 5B, at least one first plane 51 and at least one second plane 52 may be accessed through one channel, in other words, the first channel CH1 in the third channel mode. For example, the memory device 50b may receive a first chip enable signal nCE1 through a first pad P01 and output a first ready/busy signal RnB1 through a second pad P02. A third pad P03 may transmit and receive a first DQ set DQ1, and a seventh pad P07 may transmit and receive a second DQ set DQ2. The memory device 50b may receive at least one control signal CTR through a fourth pad P04. Unlike the memory device 50a of FIG. 5A described above, the memory device 50b may not use a fifth pad P05 and a sixth pad P06 in the third channel mode. For example, the memory device 50b may ignore a signal that is received through the fifth pad P05 and set the sixth pad P06 to a high impedance state.

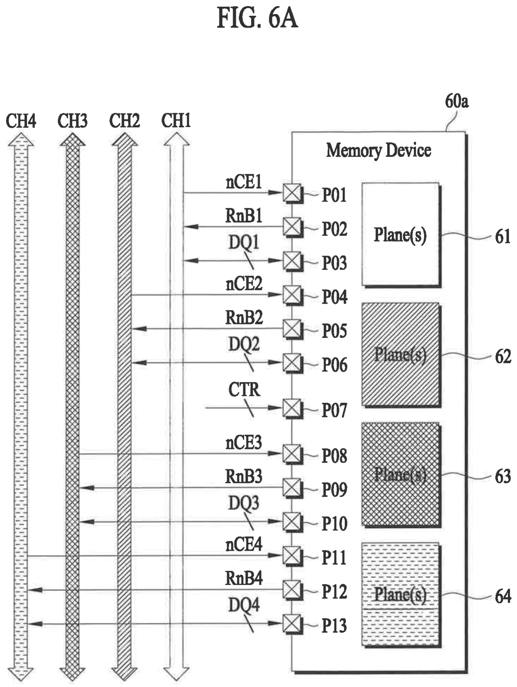

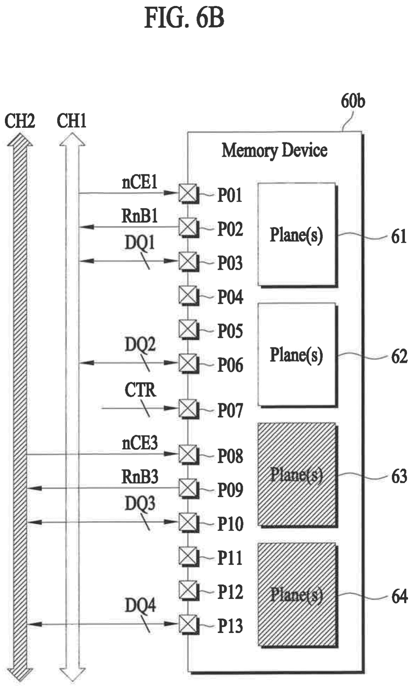

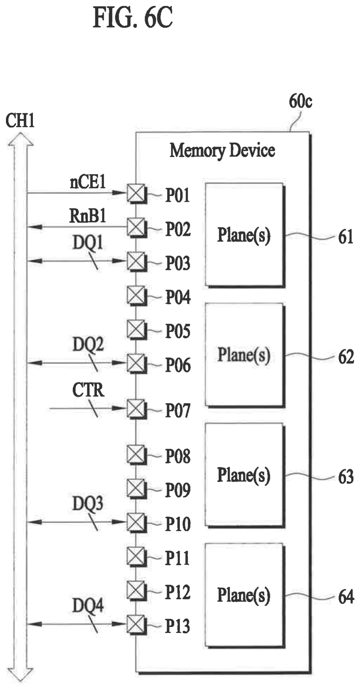

FIGS. 6A through 6C illustrate examples of a memory device according to example embodiments of the present disclosure. For example, the block diagram of FIG. 6A may indicate a memory device 60a that supports four channels and communicates through four channels, and the block diagram of FIG. 6B may indicate a memory device 60b that supports four channels and communicates through two channels, and the block diagram of FIG. 6C may indicate a memory device 60c that supports four channels and communicates through one channel. Hereinafter, redundant details in the descriptions of FIGS. 6A to 6C will be omitted.

In some example embodiments, the memory devices 60a, 60b, and 60c of FIGS. 6A to 6C may have the same structure, but may be set in different modes from one another. Hereinafter, the memory devices 60a, 60b, and 60c may be assumed to be set in a first channel mode, a second channel mode, and a third channel mode, respectively. Each of the memory devices 60a, 60b, and 60c may include at least one first plane 61, at least one second plane 62, at least one third plane 63, and at least one fourth plane 64. In addition, each of the memory devices 60a, 60b, and 60c may include a first pad P01, a second pad P02, a third pad P03, a fourth pad P04, a fifth pad P05, a sixth pad P06, a seventh pad P07, an eighth pad P08, a ninth pad P09, a tenth pad P10, an eleventh pad P11, a twelfth pad P12, and a thirteenth pad P13. Each of the memory devices 60a, 60b, and 60c may receive at least one control signal CTR through the seventh pad P07.

Referring to FIG. 6A, the at least one first plane 61, the at least one second plane 62, the at least one third plane 63, and the at least one fourth plane 64 may be respectively accessed through four channels, in other words, a first channel to a fourth channel CH1 to CH4 in the first channel mode. For example, as illustrated in FIG. 6A, the memory device 60a may receive a first chip enable signal to a fourth chip enable signal nCE1 to nCE4 through the first pad P01, the fourth pad P04, the eighth pad P08, and the eleventh pad P11, respectively. The memory device 60a may output a first ready/busy signal to a fourth ready/busy signal RnB1 to RnB4 through the second pad P02, the fifth pad P05, the ninth pad P09, and the twelfth pad P12, respectively. The memory device 60a may transmit and receive a first DQ set to a fourth DQ set DQ1 to DQ4 through the third pad P03, the sixth pad P06, the tenth pad P10, and the thirteenth pad P13, respectively.

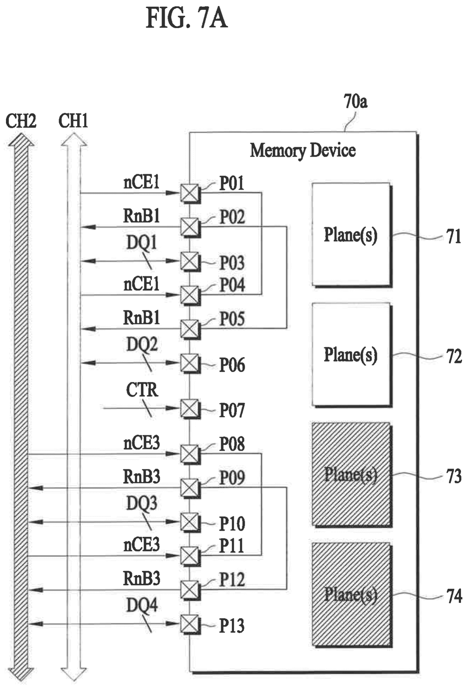

Referring to FIG. 6B, the at least one first plane 61 and the at least one second plane 62 may be accessed by a first channel CH1, and the at least one third plane 63 and the at least one fourth plane 64 may be accessed by a second channel CH2 in the second channel mode. For example, as illustrated in FIG. 6B, the memory device 60b may receive a first chip enable signal nCE1 through the first pad P01, output a first ready/busy signal RnB1 through the second pad P02, transmit and receive a first DQ set DQ1 through the third pad P03, and transmit and receive a second DQ set DQ2 through the sixth pad P06. Furthermore, the memory device 60b may receive a third chip enable signal nCE3 through the eighth pad P08, output a third ready/busy signal RnB3 through the ninth pad P09, transmit and receive a third DQ set DQ3 through the tenth pad P10, and transmit and receive a fourth DQ set DQ4 through the thirteenth pad P13. In some example embodiments, as illustrated in FIG. 6B, the fourth pad P04, the fifth pad P05, the eleventh pad P11, and the twelfth pad P12 may not be used in the second channel mode. Example embodiments where the fourth pad P04, the fifth pad P05, the eleventh pad P11, and the twelfth pad P12 are used in the second channel mode will be described later with reference to FIG. 7A.

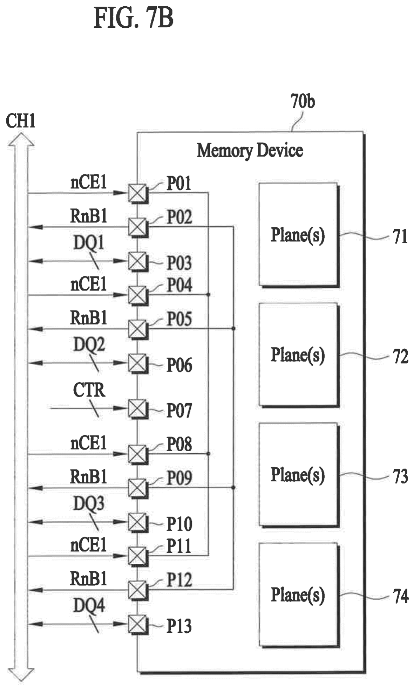

Referring to FIG. 6C, the at least one first plane 61, the at least one second plane 62, the at least one third plane 63, and the at least one fourth plane 64 may be accessed through a first channel CH1 in the third channel mode. For example, as illustrated in FIG. 6C, the memory device 60c may receive a first chip enable signal nCE1 through the first pad P01 and output a first ready/busy signal RnB1 through the second pad P02. In addition, the memory device 60c may transmit and receive a first DQ set to a fourth DQ set DQ1 to DQ4 through the third pad P03, the sixth pad P06, the tenth pad P10, and the thirteenth pad P13, respectively. In some example embodiments, as illustrated in FIG. 6C, the fourth pad P04, the fifth pad P05, the eighth pad P08, the ninth pad P09, the eleventh pad P11, and the twelfth pad P12 may not be used in the third channel mode. Example embodiments where the fourth pad P04, the fifth pad P05, the eighth pad P08, the ninth pad P09, the eleventh pad P11, and the twelfth pad P12 are used in the third channel mode will be described later with reference to FIG. 7B.

FIGS. 7A and 7B are block diagrams illustrating examples of a memory device according to example embodiments of the present disclosure. For example, the block diagram of FIG. 7A may illustrate a memory device 70a that supports four channels and communicates through two channels, and the block diagram of FIG. 7B may illustrate a memory device 70b that supports four channels and communicates through one channel. Hereinafter, redundant details in the descriptions of FIGS. 7A and 7B will be omitted.

In some example embodiments, the memory devices 70a and 70b of FIGS. 7A and 7B may have the same structure, but may be set in different modes from each other. For example, the memory device 70a of FIG. 7A may be set in a second channel mode as with the memory device 60b of FIG. 6B, and the memory device 70b of FIG. 7B may be set in a third channel mode as with the memory device 60c of FIG. 6C. Each of the memory devices 70a and 70b may include at least one first plane 71, at least one second plane 72, at least one third plane 73, and at least one fourth plane 74. In addition, each of the memory devices 70a and 70b may include a first pad P01, a second pad P02, a third pad P03, a fourth pad P04, a fifth pad P05, a sixth pad P06, a seventh pad P07, an eighth pad P08, a ninth pad P09, a tenth pad P10, an eleventh pad P11, a twelfth pad P12, and a thirteenth pad P13. Each of the memory devices 70a and 70b may receive at least one control signal CTR through the seventh pad P07. Hereinafter, redundant details in the descriptions of FIGS. 7A and 7B will be omitted.

Referring to FIG. 7A, the at least one first plane 71 and the at least one second plane 72 may be accessed by a first channel CH1, and the at least one third plane 73 and the at least one fourth plane 74 may be accessed by a second channel CH2 in the second channel mode. The memory device 70a may electrically interconnect two or more pads. For example, as illustrated in FIG. 7A, the first pad P01 and the fourth pad P04 may be interconnected and may receive a first chip enable signal nCE1. The second pad P02 and the fifth pad P05 may be interconnected and may output a first ready/busy signal RnB1. Furthermore, the eighth pad P08 and the eleventh pad P11 may be interconnected and may receive a third chip enable signal nCE3. The ninth pad P09 and the twelfth pad P12 may be interconnected and may output a third ready/busy signal RnB3. As illustrated in FIG. 7A, when the pads corresponding to an identical channel are interconnected in the memory device 70a, routing to connect pads in a package including the memory device 70a or a board where the memory device 70a is mounted may be easy.

Referring to FIG. 7B, the at least one first plane 71, the at least one second plane 72, the at least one third plane 73, and the at least one fourth plane 74 may be accessed by a first channel CH1 in the third channel mode. The memory device 70b may electrically interconnect two or more pads. For example, as illustrated in FIG. 7B, the first pad P01, the fourth pad P04, the eighth pad P08, and the eleventh pad P11 may be interconnected and may receive a first chip enable signal nCE1. The second pad P02, the fifth pad P05, the ninth pad P09, and the twelfth pad P12 may be interconnected and may output a first ready/busy signal RnB1. As illustrated in FIG. 7B, when the pads corresponding to an identical channel are interconnected in the memory device 70b, routing to connect pads in a package including the memory device 70b or a board where the memory device 70b is mounted may be easy.

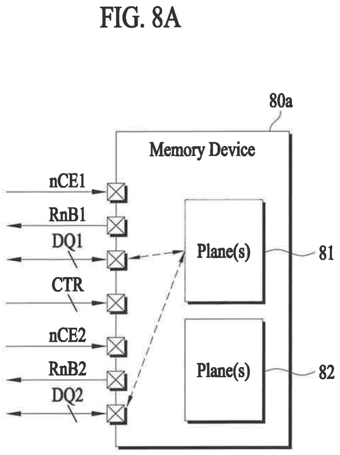

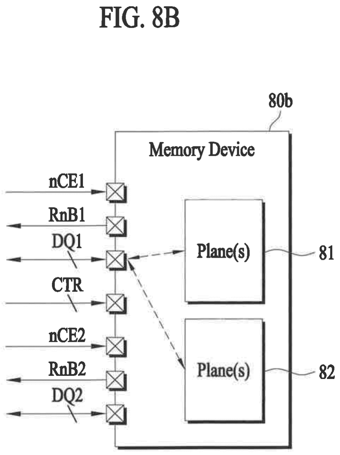

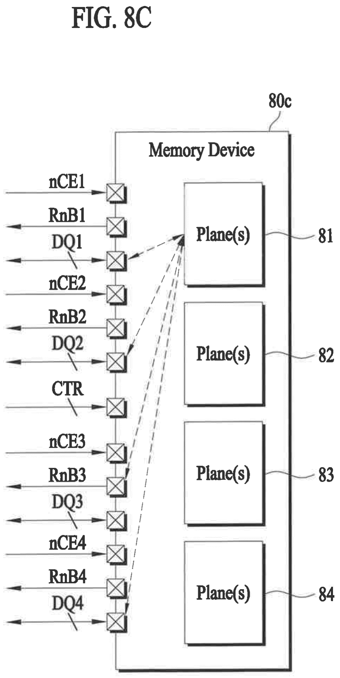

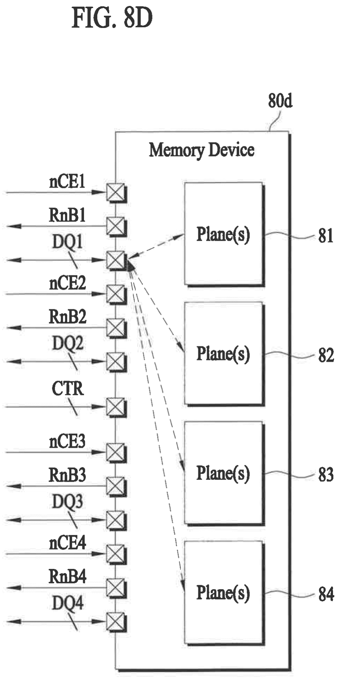

FIGS. 8A through 8D are block diagrams illustrating examples of a memory device according to example embodiments of the present disclosure. For example, the block diagrams of FIGS. 8A and 8B may illustrate memory devices 80a and 80b that support two channels, and the block diagrams of FIGS. 8C and 8D may illustrate memory devices 80c and 80d that support four channels. Redundant details described above with reference to the diagrams will be omitted in the descriptions of FIGS. 8A to 8D.

In some example embodiments, a memory device may configure a data path between a DQ set and a plane depending on a mode. In some example embodiments, as described above with reference to FIG. 2, the data path between the DQ set and the plane may be configured by I/O buffers according to a control of a control circuit. Accordingly, the memory device may provide high flexibility and high responsiveness to various operations.

As described in FIGS. 8A and 8B, each of the memory devices 80a and 80b may include at least one first plane 81 and at least one second plane 82. Each of the memory devices 80a and 80b may support two channels. Accordingly, each of the memory devices 80a and 80b may receive a first chip enable signal nCE1 and a second chip enable signal nCE2, output a first ready/busy signal RnB1 and a second ready/busy signal RnB2, and transmit and receive a first DQ set DQ1 and a second DQ set DQ2. In addition, each of the memory devices 80a and 80b may receive at least one control signal CTR.

Referring to FIG. 8A, when the memory device 80a is set in a first data path mode, a data path between the first DQ set DQ1 and the at least one first plane 81 and a data path between the second DQ set DQ2 and the at least one first plane 81 may be configured. Accordingly, the first DQ set DQ1 and the second DQ set DQ2 may be used to write data in the at least one first plane 81 or read data from the at least one first plane 81.

Referring to FIG. 8B, when the memory device 80b is set in a second data path mode, a data path between the first DQ set DQ1 and the at least one first plane 81 and a data path between the first DQ set DQ1 and the at least one second plane 82 may be configured. Accordingly, the first DQ set DQ1 may be used to write data in the at least one first plane 81 and the at least one second plane 82, or read data from the at least one first plane 81 and the at least one second plane 82.

As illustrated in FIGS. 8C and 8D, each of the memory devices 80c and 80d may include at least one first plane 81, at least one second plane 82, at least one third plane 83, and at least one fourth plane 84. Each of the memory devices 80c and 80d may support four channels. Accordingly, each of the memory devices 80c and 80d may receive a first chip enable signal nCE1 to a fourth chip enable signal nCE4, output a first ready/busy signal RnB1 to a fourth ready/busy signal RnB4, and transmit and receive a first DQ set DQ1 to a fourth DQ set DQ4. In addition, each of the memory devices 80c and 80d may receive at least one control signal CTR.

Referring to FIG. 8C, when the memory device 80c is set in a first data path mode, a data path between the first DQ set to the fourth DQ set DQ1 to DQ4 and the at least one first plane 81 may be configured. Accordingly, the first DQ set to the fourth DQ set DQ1 to DQ4 may be used to write data in the at least one first plane 81 or read data from the at least one first plane 81.

Referring to FIG. 8D, when the memory device 80d is set in a second data path mode, a data path between the first DQ set DQ1 and the at least one first plane 81, a data path between the first DQ set DQ1 and the at least one second plane 82, a data path between the first DQ set DQ1 and the at least one third plane 83, and a data path between the first DQ set DQ1 and the at least one fourth plane 84 may be configured. Accordingly, the first DQ set DQ1 may be used to write data in the at least one first plane 81, the at least one second plane 82, the at least one third plane 83, and the at least one fourth plane 84, or read data from the at least one first plane 81, the at least one second plane 82, the at least one third plane 83, and the at least one fourth plane 84.

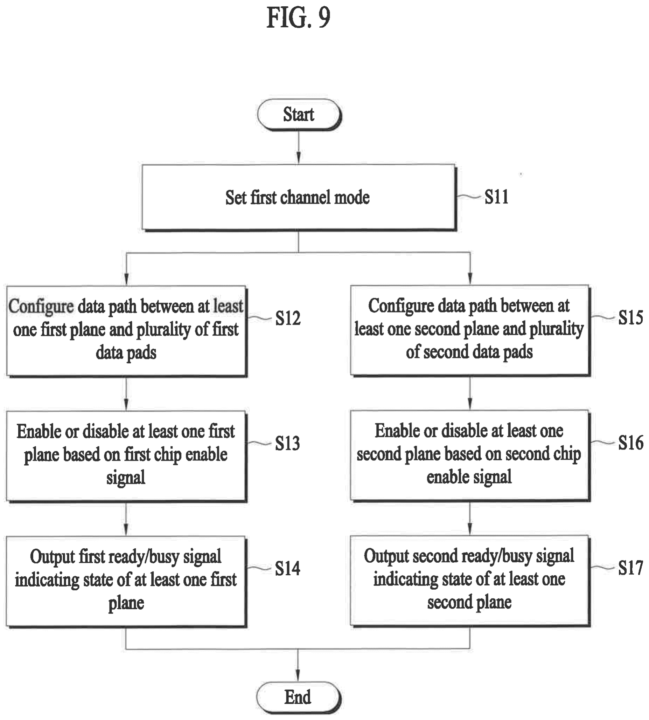

FIG. 9 is a flowchart illustrating an operating method of a memory device according to an example embodiment of the present disclosure. For example, the flowchart of FIG. 9 may illustrate an operating method of the memory device that is set in a first channel mode. In some example embodiments, the method of FIG. 9 may be performed by the memory device 30b of FIG. 3B. As illustrated in FIG. 9, the operating method of the memory device may include a plurality of operations S11 to S17. Hereinafter, FIG. 9 will be described with reference to FIG. 3B.

Referring to FIG. 9, a first channel mode may be set in operation S11. For example, the memory device 30b may set the first channel mode based on a signal received from the outside. As described above with reference to FIGS. 3B, 5A, and 5B, the memory device 30b may communicate through two or more channels in the first channel mode. As illustrated in FIG. 9, operations S12 and S13 may be performed in parallel to operations S15 and S17.

In operation S12, a data path between the at least one first plane 31 and a plurality of first data pads may be configured. For example, the third pad P03 that transmits and receives the first DQ set DQ1 may include a plurality of pads, in other words, a plurality of data pads, and the memory device 30b may configure a data path between the at least one first plane 31 and the third pad P03.

In operation S13, the at least one first plane 31 may be enabled or disabled based on the first chip enable signal nCE1. For example, the control circuit of the memory device 30b may enable the at least one first plane 31 in response to an activated first chip enable signal nCE1. In addition, the control circuit of the memory device 30b may disable the at least one first plane 31 in response to an inactivated first chip enable signal nCE1.

In the operation S14, the first ready/busy signal RnB1 that indicates a state of the at least one first plane 31 may be output. For example, the control circuit of the memory device 30b may output the activated first ready/busy signal RnB1 when the at least one first plane 31 is in the ready state. In addition, the control circuit of the memory device 30b may output the inactivated first ready/busy signal RnB1 when the at least one first plane 31 is in the busy state.

In operation S15, a data path between the at least one second plane 32 and a plurality of second data pads may be configured. For example, the seventh pad P07 that transmits and receives the second DQ set DQ2 may include a plurality of pads, in other words, a plurality of data pads, and the memory device 30b may configure a data path between the at least one second plane 32 and the seventh pad P07.

In operation S16, the at least one second plane 32 may be enabled or disabled based on the second chip enable signal nCE2. For example, the control circuit of the memory device 30b may enable the at least one second plane 32 in response to an activated second chip enable signal nCE2. In addition, the control circuit of the memory device 30b may disable the at least one second plane 32 in response to an inactivated second chip enable signal nCE2.

In operation S17, the second ready/busy signal RnB2 that indicates a state of the at least one second plane 32 may be output. For example, the control circuit of the memory device 30b may output the activated second ready/busy signal RnB2 when the at least one second plane 32 is in the ready state. In addition, the control circuit of the memory device 30b may output the inactivated second ready/busy signal RnB2 when the at least one second plane 32 is in the busy state.

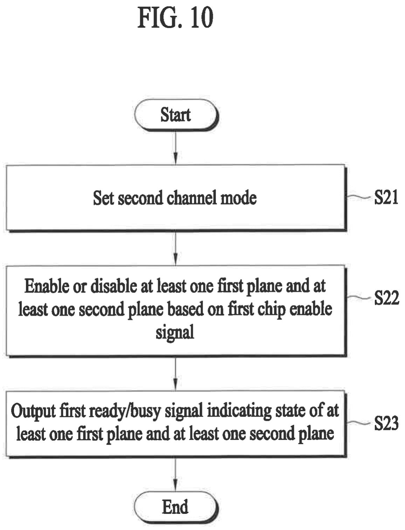

FIG. 10 is a flowchart illustrating an operation of a memory device according to an example embodiment of the present disclosure. For example, the flowchart of FIG. 10 may illustrate the operation of the memory device that is set in a second channel mode. In some example embodiments, the method of FIG. 10 may be performed by the memory devices 50a and 50b of FIGS. 5A and 5B. As illustrated in FIG. 10, the operating method of the memory device may include a plurality of operations S21 to S23. Hereinafter, FIG. 10 will be described with reference to FIG. 5A.

Referring to FIG. 10, a second channel mode may be set in operation S21. For example, the memory device 50a may set the second channel mode based on a signal received from the outside. As described above with reference to FIGS. 5A and 5B, the memory device 50a may communicate through one channel in the second channel mode.

In operation S22, the at least one first plane 51 and the at least one second plane 52 may be enabled or disabled based on the first chip enable signal nCE1. For example, the control circuit of the memory device 50a may enable the at least one first plane 51 and the at least one second plane 52 in response to an activated first chip enable signal nCE1. In addition, the control circuit of the memory device 50a may disable the at least one first plane 51 and the at least one second plane 52 in response to an inactivated first chip enable signal nCE1.

In the operation S23, the first ready/busy signal RnB1 that indicates a state of the at least one first plane 51 and the at least one second plane 52 may be output. For example, a control circuit of the memory device 50a may output an activated first ready/busy signal RnB1 when the at least one first plane 51 and the at least one second plane 52 are in a ready state. In addition, the control circuit of the memory device 50a may output an inactivated first ready/busy signal RnB1 when the at least one first plane 51 and the at least one second plane 52 are in a busy state.

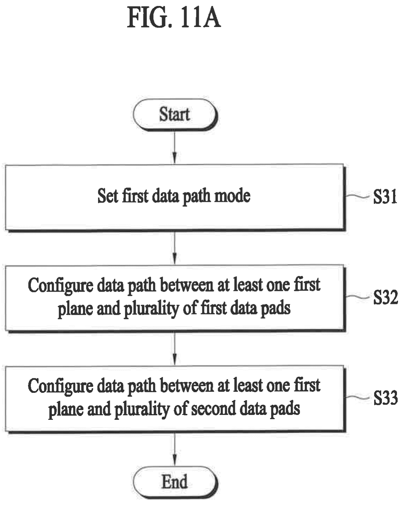

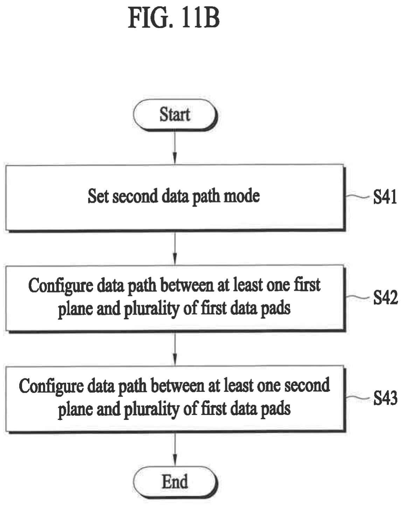

FIGS. 11A and 11B are flowcharts illustrating examples of an operating method of a memory device according to example embodiments of the present disclosure. For example, the flowcharts of FIGS. 11A and 11B may illustrate examples of a method of configuring a data path in the memory device. In some example embodiments, the method of FIG. 11A may be performed by the memory device 80a of FIG. 8A, and the method of FIG. 11B may be performed by the memory device 80b of FIG. 8B. Hereinafter, FIGS. 11A and 11B will be described with reference to FIGS. 8A and 8B.

Referring to FIG. 11A, the operating method of the memory device may include a plurality of operations S31 to S33. In operation S31, the first data path mode may be configured. For example, a control circuit of the memory device 80a may configure the first data path mode based on a signal received from the outside.

In operation S32, a data path between the at least one first plane 81 and a plurality of first data pads may be configured. For example, as illustrated in FIG. 8A, the memory device 80a may include a plurality of first data pads that transmit and receive the first DQ set DQ1. The memory device 80a may configure a data path between the at least one first plane 81 and the plurality of first data pads.

In operation S33, a data path between the at least one first plane 81 and a plurality of second data pads may be configured. For example, as illustrated in FIG. 8A, the memory device 80a may include the plurality of second data pads that transmit and receive the second DQ set DQ2. The memory device 80a may configure a data path between the at least one first plane 81 and the plurality of second data pads.

As illustrated in FIG. 11B, the operating method of a memory device may include a plurality of operations S41 to S43. In operation S41, a second data path mode may be set. For example, the control circuit of the memory device 80b may set the second data path mode based on a signal received from the outside.

In operation S42, a data path between the at least one first plane 81 and a plurality of first data pads may be configured. For example, as illustrated in FIG. 8B, the memory device 80b may include the plurality of first data pads that transmit and receive the first DQ set DQ1. The memory device 80b may configure a data path between the at least one first plane 81 and the plurality of first data pads.

In operation S43, a data path between the at least one second plane 82 and a plurality of first data pads may be configured. For example, as illustrated in FIG. 8B, the memory device 80b may include the plurality of first data pads that transmit and receive the first DQ set DQ1. The memory device 80b may configure a data path between the at least one second plane 82 and the plurality of first data pads.

FIG. 12 is a diagram illustrating a storage device 120 according to an example embodiment of the present disclosure. For example, FIG. 12 may illustrate the storage device 120 including a plurality of memory devices in one package, and the storage device 120 may be simply referred to as a storage.

Referring to FIG. 12, the storage device 120 may include a first memory die to a sixteenth memory die M01 to M16 and a control die C01. It should be noted that the number of memory dies included in the storage device 120 is not limited to what is illustrated in FIG. 12. Each of the first memory die to the sixteenth memory die M01 to M16 may correspond to a memory device that is described above with reference to the diagrams, and the control die C01 may correspond to the memory controller 11 of FIG. 1. Each of the first memory die to the sixteenth memory die M01 to M16 may have wide I/O, and the storage device 120 may have wide bandwidth. When the first memory die to the sixteenth memory die M01 to M16 are flash memories, the storage device 120 may be referred to as a high bandwidth flash (HBF). The control die C01 may provide accesses to the first memory die to the sixteenth memory die M01 to M16 from outside the storage device 120. In addition, the control die C01 may set a mode of each of the first memory die to the sixteenth memory die M01 to M16, for example, a channel mode and/or a data path mode, either autonomously or in response to a request from outside the storage device 120.

Each of the first memory die to the sixteenth memory die M01 to M16 may communicate with the control die C01 through two or more channels. Each of the first memory die to the sixteenth memory die M01 to M16 may include a plurality of planes, and each of the two or more channels may be used to access to at least one of the plurality of planes. As described above with reference to the diagrams, a single channel may include a chip enable signal, a ready/busy signal, and a DQ set, and each of the first memory die to the sixteenth memory die M01 to M16 may include pads that correspond to the chip enable signal, the ready/busy signal, and the DQ set.

In some example embodiments, a memory die may include through silicon vias for the chip enable signal and the ready/busy signal. For example, as illustrated in FIG. 12, the sixteenth memory die M16 may include a first through silicon via TSV1 corresponding to a pad that receives a first chip enable signal from the control die C01 and a second through silicon via TSV2 corresponding to a pad that outputs a first ready/busy signal to the control die C01. In addition, the sixteenth memory die M16 may include a third through silicon via TSV3 corresponding to a pad that receives a second chip enable signal from the control die C01 and a fourth through silicon via TSV4 corresponding to a pad that outputs a second ready/busy signal to the control die C01. In some example embodiments, as illustrated in FIG. 12, each of the first memory die to the fifteenth memory die M01 to M15 may include through silicon vias of the sixteenth memory die M16 for the first chip enable signal, the second chip enable signal, the first ready/busy signal, and the second ready/busy signal.

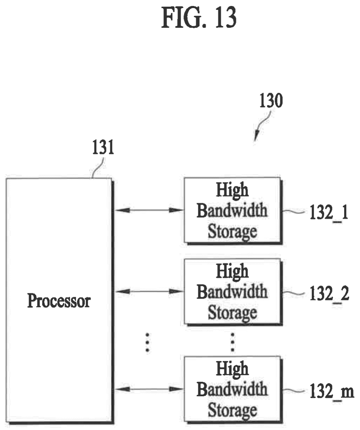

FIG. 13 is a block diagram illustrating a system 130 according to an example embodiment of the present disclosure. As illustrated in FIG. 13, the system 130 may include a processor 131 and a first high-bandwidth storage to an m high-bandwidth storage 132_1 to 132_m. In some example embodiments, the system 130 may correspond to one package, and the processor 131 and the first high-bandwidth storage to the m high-bandwidth storage 132_1 to 132_m may be mounted on an interposer in one package. In some example embodiments, the system 130 may correspond to one module, and packages, each of which includes the processor 131 and the first high-bandwidth storage to the m high-bandwidth storage 132_1 to 132_m, may be mounted on a board.

The processor 131 may be a random component that processes data. For example, the processor 131 may be a processor that executes a software code, a fixed intellectual property (IP) such as a hardware accelerator, or a reconfigurable component such as a field programmable gate array (FPGA). In addition, the processor 131 may be a component that is designed for parallel processing such as a graphic processing unit (GPU) or a neural processing unit (NPU).

The processor 131 may access to the first high-bandwidth storage to the m high-bandwidth storage 132_1 to 132_m. The processor 131 may store data to the first high-bandwidth storage to the m high-bandwidth storage 132_1 to 132_m or read data that is stored in the first high-bandwidth storage to the m high-bandwidth storage 132_1 to 132_m. In some example embodiments, each of the first high-bandwidth storage to the m high-bandwidth storage 132_1 to 132_m may correspond to the storage device of FIG. 12 and may be referred to as an HBF when including a flash memory. As described above with reference to the diagrams, the memory device that is included in the first high-bandwidth storage to the m high-bandwidth storage 132_1 to 132_m may not only have wide I/O but also provide a plurality of channels. In addition, the memory device may support various modes. Accordingly, the first high-bandwidth storage to the m high-bandwidth storage 132_1 to 132_m may provide high bandwidth and flexibility to the processor 131 and performance of the system 130 may increase.

## Claims

1. A memory device (20), comprising:
a plurality of planes (22) included in a chip, and each of which includes a cell array and a page buffer; and
a control circuit (25),
wherein the control circuit (25), in a first mode, is configured to:
enable or disable at least one first plane (31) among the plurality of planes (22) based on a signal (nCE1) received through a first chip enable pad (P01) and output a signal (RnB1) that indicates a state of the at least one first plane (31) through a first ready/busy pad (P02); and
enable or disable at least one second plane (32) among the plurality of planes (22) based on a signal (nCE2) received through a second chip enable pad (P05) and output a signal (RnB2) that indicates a state of the at least one second plane (32) through a second ready/busy pad (P06).

2. The memory device (20) of claim 1,
wherein the control circuit (25), in a second mode, is configured to enable or disable the at least one first plane (31) and the at least one second plane (32) based on a signal (nCE1) received through the first chip enable pad (P01) and output a signal (RnB1) that indicates a state of the at least one first plane (31) and the at least one second plane (32) through the first ready/busy pad (P02).

3. The memory device (20) of claim 2,
wherein the control circuit (25), in the second mode, is configured to ignore a signal (nCE2) received through the second chip enable pad (P05) and configure the second ready/busy pad (P06) in a high-impedance state.

4. The memory device (20) of claim 2 or 3,
wherein the control circuit (25), in the second mode, is configured to electrically connect the first chip enable pad (P01) and the second chip enable pad (P05) and electrically connect the first ready/busy pad (P02) and the second ready/busy pad (P06).

5. The memory device (20) of any one of claims 1 to 4, further comprising an input/output, I/O, buffer connected to a plurality of first data pads (P03) and a plurality of second data pads (P07), and
wherein the control circuit (25), in the first mode, is configured to control the I/O buffer (23) to form a data path between the at least one first plane (31) and the plurality of first data pads (P03) and to form a data path between the at least one second plane (32) and the plurality of second data pads (P07).

6. The memory device (20) of claim 5,
wherein the control circuit (25), in a third mode, is configured to control the I/O buffer (23) to form a data path between the at least one first plane (31) and the plurality of first data pads (P03) and to form a data path between the at least one first plane (31) and the plurality of second data pads (P07).

7. The memory device (20) of claim 5 or 6,
wherein the control circuit (25), in a fourth mode, is configured to control the I/O buffer (23) to form a data path between the at least one first plane (31) and the plurality of first data pads (P03) and to form a data path between the at least one second plane (32) and the plurality of first data pads (P03).

8. The memory device (20) of any one of claims 1 to 7,
wherein the control circuit (25) is configured to set the first mode based on a signal received through at least one pad.

9. The memory device (20) of any one of claims 1 to 8,
wherein the control circuit (25) is configured to control the at least one first plane (31) and the at least one second plane (32) based on a control signal (CTR) received through a control pad (CTR).

10. The memory device (60b) of any one of claims 1 to 9,
wherein the control circuit (25), in the first mode, is configured to:
enable or disable at least one third plane (63) among the plurality of planes (22) based on a signal (nCE3) received through a third chip enable pad (P08) and output a signal (RnB4) that indicates a state of the at least one third plane (63) through a third ready/busy pad (P09); and
enable or disable at least one fourth plane (64) among the plurality of planes (22) based on a signal (nCE4) received through a fourth chip enable pad (P11) and output a signal (RnB4) that indicates a state of the at least one fourth plane (64) through a fourth ready/busy pad (P12).

11. The memory device (20) of any one of claims 1 to 10, further comprising a first through silicon via (TSV1), a second through silicon via (TSV2), a third through silicon via (TSV3), and a fourth through silicon via (TSV4) that penetrate the chip and correspond to the first chip enable pad (P01), the first ready/busy pad (P02), the second chip enable pad (P05), and the second ready/busy pad (P06), respectively.

12. An operating method of a memory device (20) including a plurality of planes (22) included in a chip, and each of which includes a cell array and a page buffer, the operating method comprising:
in a first mode, enabling or disabling at least one first plane (31) among the plurality of planes (22) based on a signal (nCE1) received through a first chip enable pad (P01);
in the first mode, outputting a signal (RnB1) that indicates a state of the at least one first plane (31) through a first ready/busy pad (P02);
in the first mode, enabling or disabling at least one second plane (32) among the plurality of planes (22) based on a signal (nCE2) received through a second chip enable pad (P05); and
in the first mode, outputting a signal (RnB2) that indicates a state of the at least one second plane (32) through a second ready/busy pad (P06).

13. The operating method of claim 12, further comprising:
in a second mode, enabling or disabling the at least one first plane (31) and the at least one second plane (32) based on a signal (nCE1) received through the first chip enable pad (P01); and
in the second mode, outputting a signal (RnB2) that indicates a state of the at least one first plane (31) and the at least one second plane (32) through the first ready/busy pad (P02).

14. The operating method of claim 12 or 13, further comprising:
in the first mode, forming a data path between the at least one first plane (31) and a plurality of first data pads (P03); and
in the first mode, forming a data path between the at least one second plane (32) and a plurality of second data pads (P07).

15. The operating method of claim 14, further comprising:
in a third mode, forming a data path between the at least one first plane (31) and the plurality of first data pads (P03); and
in the third mode, forming a data path between the at least one first plane (31) and the plurality of second data pads (P07).
